# EUROPÄISCHE PATENTSCHRIFT

(11) **EP 2 360 484 B1**
(45) Veröffentlichungstag und Bekanntmachung des Hinweises auf die Patenterteilung: **17.10.2018**
(21) Anmeldenummer: 11000456.1
(22) Anmeldetag: 21.01.2011
(51) Int. Cl.: G01D 4/00, G01R 29/10, G08C 17/02, H04L 5/14

(54) **Bidirektionales Funk-Datenübertragungsverfahren**
Bidirectional wireless data transmission method
Procédé de transmission de données radio bidirectionnel

(30) Priorität: 22.01.2010 DE 102010005587
(43) Veröffentlichungstag der Anmeldung: 24.08.2011
(73) Patentinhaber: Diehl Metering Systems GmbH, 90451 Nürnberg (DE)
(72) Erfinder: Gottschalk, Klaus, 90610 Winkelhaid (DE); Kauppert, Thomas, 90489 Nürnberg (DE)
(74) Vertreter: Diehl Patentabteilung

(56) Entgegenhaltungen:
- EP-A2- 1 365 517
- DE-A1-102004 041 421
- DE-T2- 69 002 479
- US-A1- 2006 066 455
- US-A1- 2007 013 547
- US-A1- 2009 204 265

## Beschreibung

Die Erfindung betrifft ein bidirektionales Funk-Datenübertragungsverfahren nach dem Oberbegriff des Patentanspruchs 1 sowie ein Funk-Datenübertragungssystem.

Verbrauchsmesswerte z. B. für Wasser, Gas, Strom, Wärme, Kälte oder Energie werden von den entsprechenden Verbrauchsmessern immer öfter per Funk an entsprechende Datensammler übermittelt. Die betreffenden Verbrauchsmesswerte liegen dabei als digitale Daten vor. Um hierbei möglichst wenige Datensammler zu benötigen und trotzdem alle betreffenden Verbrauchsmesser auslesen zu können, ist es wünschenswert, dass die Datenübertragung über eine möglichst große Reichweite erfolgen kann. Da die in den Verbrauchsmessern angeordneten Funksender jedoch meist batteriebetrieben sind, kann deren Sendeleistung mit Rücksicht auf die Batterielebensdauer nicht beliebig gesteigert werden. Außerdem beschränken die geltenden europäischen Normen EN 13757-4 und EN 300 220 die in den freigegebenen Frequenzbändern bei 868,95 MHz und 869,525 MHz verwendete Abstrahlleistung der jeweiligen Funksender.

Aus der EP 1 365 517 A2 ist eine Eingangsschaltung für einen integrierten HF-Sendebaustein bekannt, der z. B. in einem batteriebetriebenen Verbrauchsmessgerät, d. h. dem Endgerät, verwendet wird, um Verbrauchsdaten zu übertragen.

Die US 2006/066455 A1 beschreibt ein Verfahren zum Gruppieren von Maschenclustern, bei dem ein erster Maschencluster mittels einer ersten RF (radio frequency)-Vorrichtung Energiedaten an einen zweiten Maschencluster überträgt, der hierzu eine zweite RF-Vorrichtung umfasst. Um die Energiedaten zwischen dem ersten Maschencluster und dem zweiten Maschencluster zu übertragen, besteht eine Verbindung zwischen der ersten RF-Vorrichtung des ersten Maschenclusters und der zweiten RF-Vorrichtung des zweiten Maschenclusters. Die Verbindung wird hierbei über Richtantennen hergestellt, die sowohl an der ersten RF-Vorrichtung als auch an der zweiten RF-Vorrichtung vorgesehen sind. Die Übertragung über die Richtantennen zwischen zwei RF-Vorrichtungen verschiedener Maschencluster erfolgt hierbei in einer höheren Frequenz als die Übertragung zwischen zwei RF-Vorrichtungen innerhalb eines Maschenclusters.

Falls die Funk-Datenübertragung lediglich unidirektional, also nur vom Verbrauchsmesser zum Datensammler ausgeführt ist, kann beim Datensammler eine Richtantenne verwendet werden, welche durch ihre Richtcharakteristik des Funkempfangs die Empfangsempfindlichkeit des Funkempfängers erhöht, wodurch die Reichweite der Funkübertragung vergrößert wird.

Im Falle einer bidirektionalen Funk-Datenübertragung (also sowohl vom Verbrauchsmesser zum Datensammler als auch vom Datensammler zum Verbrauchsmesser) ist die Verwendung einer Richtantenne nicht zulässig, da die durch sie abgestrahlte Sendeleistung erhöht wäre und somit die im verwendeten Frequenzband zulässige maximale Sendeleistung überschritten würde. Somit müsste die Sendeleistung entsprechend reduziert werden, was wiederum die Reichweite der Datenübertragung verringern würde.

Die Ausstattung der Verbrauchsmesser mit Richtantennen ist sowohl aus Kostenals auch aus praktikablen Gründen nicht möglich. Damit könnte die Erhöhung der Funkreichweite im bidirektionalen Betrieb nur in eine Richtung (nämlich zur Richtantenne des Datensammlers hin) erreicht werden, nicht jedoch in Gegenrichtung (von der Richtantenne weg), da ansonsten die europäischen Normen EN 390 220 und EN 13757-4 verletzt werden würden.

Aufgabe der Erfindung ist es nun, ein bidirektionales Funk-Datenübertragungsverfahren vorzuschlagen, welches eine höhere Reichweite ermöglicht, ohne dass die genannten Normen verletzt werden.

Gemäß der Erfindung wird diese Aufgabe dadurch gelöst, dass ein als Datensammler oder Energiesteuergerät ausgebildetes Zentralgerät mit einer Richtantenne arbeitet, dass für die Datenübertragung vom Zentralgerät zu einem Endgerät, das als Verbrauchsmesswerte aufnehmender Verbrauchsmesser oder als ferngesteuerter oder tarifgesteuerter Energieverbraucher oder Energieerzeuger ausgebildet ist, ein Frequenzband verwendet wird, welches für eine höhere Sendeleistung vorgesehen ist als das Frequenzband, das für die Datenübertragung vom Endgerät zum Zentralgerät verwendet wird und dass gleichzeitig der Frequenzhub der Datenübertragung vom Zentralgerät zum Endgerät der Frequenzbreite des für diese Datenübertragung verwendeten Frequenzbandes angepasst ist. Das Frequenzband für die Datenübertragung vom Endgerät zum Zentralgerät liegt vorzugsweise bei 868,95 MHz und weist eine Bandbreite von etwa 500 kHz auf, während das Frequenzband für die Datenübertragung vom Zentralgerät zum Endgerät bei 869,525 MHz liegt und eine Bandbreite von etwa 250 kHz aufweist. Ferner liegt der Frequenzhub der digitalen Datenübertragung vom Endgerät zum Zentralgerät zwischen 40 kHz und 80 kHz während der Frequenzhub der digitalen Datenübertragung vom Zentralgerät zum Endgerät zwischen 10 kHz und 20 kHz liegt.

Auf diese Weise ist gewährleistet, dass die Reichweite der Funk-Datenübertragung nicht nur für Übertragungen vom Endgerät zum Zentralgerät aufgrund der Verwendung der Richtantenne erhöht ist, sondern dass gleichzeitig auch die Reichweite der Funk-Datenübertragung von dem mit einer Richtantenne arbeitenden Zentralgerät zum Endgerät aufgrund der höheren zugelassenen Sendeleistung vergrößert ist. Damit ist eine symmetrische Funkverbindung zwischen Endgerät und Zentralgerät gegeben.

Das Frequenzband für die Datenübertragung vom Endgerät zum Zentralgerät weist vorzugsweise eine zulässige Sendeleistung von 25 mW auf, während das Frequenzband für die Datenübertragung vom Zentralgerät zum Endgerät eine zulässige Sendeleistung von 500 mW aufweist.

In bevorzugter Ausgestaltung der Erfindung liegt der Frequenzhub der digitalen Datenübertragung vom Endgerät zum Zentralgerät bei 50 kHz während der Frequenzhub der digitalen Datenübertragung vom Zentralgerät zum Endgerät bei 15 kHz liegt.

Weiter erfolgt gemäß bevorzugter Ausführungsform die Datenübertragung vom Endgerät zum Zentralgerät mit einer Datenrate von 100 kcps mit einer sog. 3-aus-6-Kodierung, während die Übertragung vom Zentralgerät zum Endgerät mit einer Datenrate von 32 kcps mit einer sog. Manchester-Kodierung erfolgt.

Ein bidirektionales Funk-Datenübertragungssystem zur Durchführung dieses Verfahrens weist ein batteriebetriebenes Endgerät mit Funksender, Funkempfänger und Funkantenne sowie ein Zentralgerät mit Funksender, Funkempfänger und einer Funkantenne mit Richtwirkung auf.

## Patentansprüche

1. Bidirektionales Funk-Datenübertragungsverfahren zur Übertragung digitaler Verbrauchsmess- oder Energiemanagement-Daten zwischen einem Endgerät, das als Verbrauchsmesswerte aufnehmender Verbrauchsmesser oder als ferngesteuerter oder tarifgesteuerter Energieverbraucher oder Energieerzeuger ausgebildet ist, und einem Zentralgerät, das als Datensammler oder Energiesteuergerät ausgebildet ist, wobei die Datenübertragung vom Endgerät zum Zentralgerät in einem ersten Frequenzband erfolgt und das Zentralgerät mit einer Richtantenne arbeitet,
**dadurch gekennzeichnet,**
**dass** die Datenübertragung vom Zentralgerät zum Endgerät in einem zweiten Frequenzband erfolgt und das zweite Frequenzband für eine höhere Sendeleistung als das erste Frequenzband ausgestaltet ist, das erste Frequenzband bei 868,95 MHz liegt und eine Bandbreite von etwa 500 kHz aufweist, während das zweite Frequenzband bei 869,525 MHz liegt und eine Bandbreite von etwa 250 kHz aufweist, und gleichzeitig der Frequenzhub der Datenübertragung vom Zentralgerät zum Endgerät der Frequenzbandbreite des zweiten Frequenzbandes angepasst ist, derart, dass der Frequenzhub der Datenübertragung vom Endgerät zum Zentralgerät zwischen 40 kHz und 80 kHz und der Frequenzhub der Datenübertragung vom Zentralgerät zum Endgerät zwischen 10 kHz und 20 kHz liegt.

2. Bidirektionales Funk-Datenübertragungsverfahren nach Anspruch 1,
**dadurch gekennzeichnet,**
**dass** der Frequenzhub der Datenübertragung im ersten Frequenzband bei 50 kHz und der Frequenzhub der Datenübertragung im zweiten Frequenzband bei 15 kHz liegt.

3. Bidirektionales Funk-Datenübertragungsverfahren nach Anspruch 1 oder 2, **dadurch gekennzeichnet,**
**dass** die Übertragung vom Endgerät zum Zentralgerät mit einer Datenrate von 100 kcps und einer 3-aus-6-Kodierung erfolgt.

4. Bidirektionales Funk-Datenübertragungsverfahren nach einem der vorherigen Ansprüche,
**dadurch gekennzeichnet,**
**dass** die Übertragung vom Zentralgerät zum Endgerät mit einer Datenrate von 32 kcps und einer Manchester-Kodierung erfolgt.

5. Bidirektionales Funk-Datenübertragungssystem mit einem einen Funksender, einen Funkempfänger und eine Funkantenne aufweisenden, batteriebetriebenen Endgerät und einem einen Funksender, einen Funkempfänger und eine Richtantenne aufweisenden Zentralgerät,
**dadurch gekennzeichnet,**
**dass** das Funk-Datenübertragungssystem zur Durchführung des Verfahrens nach einem der vorherigen Ansprüche ausgestaltet ist.

## Claims

1. Bidirectional radio data transmission method for transmitting digital consumption measurement or energy management data between a terminal, which is configured as a consumption meter recording consumption measurement values or as a remote-controlled or tariff-controlled energy consumer or energy producer, and a central device, which is configured as a data collector or energy controller, wherein the data transmission from the terminal to the central device takes place in a first frequency band and the central device uses a directional antenna,
**characterized**
**in that** the data transmission from the central device to the terminal takes place in a second frequency band and the second frequency band is configured for a higher transmission power than the first frequency band, the first frequency band is at 868.95 MHz and has a bandwidth of approximately 500 kHz, while the second frequency band is at 869.525 MHz and has a bandwidth of approximately 250 kHz, and at the same time the frequency swing of the data transmission from the central device to the terminal matches the frequency bandwidth of the second frequency band such that the frequency swing of the data transmission from the terminal to the central device is between 40 kHz and 80 kHz and the frequency swing of the data transmission from the central device to the terminal is between 10 kHz and 20 kHz.

2. Bidirectional radio data transmission method according to Claim 1,
**characterized**
**in that** the frequency swing of the data transmission in the first frequency band is 50 kHz and the frequency swing of the data transmission in the second frequency band is 15 kHz.

3. Bidirectional radio data transmission method according to Claim 1 or 2,
**characterized**
**in that** the transmission from the terminal to the central device takes place at a data rate of 100 kcps and using 3-out-of-6 encoding.

4. Bidirectional radio data transmission method according to one of the preceding claims,
**characterized**
**in that** the transmission from the central device to the terminal takes place at a data rate of 32 kcps and using Manchester encoding.

5. Bidirectional radio data transmission system with a battery-operated terminal, having a radio transmitter, a radio receiver and a radio antenna, and a central device, having a radio transmitter, a radio receiver and a directional antenna,
**characterized**
**in that** the radio data transmission system is configured for performing the method according to one of the preceding claims.

## Revendications

1. Procédé de transmission de données de radiocommunication bidirectionnelle, destiné à la transmission de données numériques de mesure de consommation ou de gestion d'énergie entre un terminal, qui est réalisé sous la forme d'un compteur de consommation qui enregistre les valeurs mesurées de consommation ou sous la forme d'un récepteur d'énergie ou d'un générateur d'énergie commandé à distance ou commandé en fonction du tarif, et un appareil central, qui est réalisé sous la forme d'un collecteur de données ou d'un contrôleur d'énergie, la transmission de données du terminal vers l'appareil central s'effectuant dans une première bande de fréquences et l'appareil central fonctionnant avec une antenne directive,
**caractérisé en ce que** la transmission de données de l'appareil central vers le terminal s'effectue dans une deuxième bande de fréquences et la deuxième bande de fréquences est équipée pour une puissance d'émission supérieure à celle de la première bande de fréquences, la première bande de fréquences est de l'ordre de 868,95 MHz et possède une largeur de bande d'environ 500 kHz, alors que la deuxième bande de fréquences est de l'ordre de 869,525 MHz et possède une largeur de bande d'environ 250 kHz, et, simultanément, l'excursion de fréquence de la transmission de données de l'appareil central vers le terminal est adaptée à la largeur de bande de fréquences de la deuxième bande de fréquences de telle sorte que l'excursion de fréquence de la transmission de données du terminal vers l'appareil central est comprise entre 40 kHz et 80 kHz et l'excursion de fréquence de l'appareil central vers le terminal est comprise entre 10 kHz et 20 kHz.

2. Procédé de transmission de données de radiocommunication bidirectionnelle selon la revendication 1, **caractérisé en ce que** l'excursion de fréquence de la transmission de données dans la première bande de fréquences est de 50 kHz et l'excursion de fréquence de la transmission de données dans la deuxième bande de fréquences est de 15 kHz.

3. Procédé de transmission de données de radiocommunication bidirectionnelle selon la revendication 1 ou 2, **caractérisé en ce que** la transmission du terminal vers l'appareil central s'effectue avec un débit de données de 100 kcps et un codage 3 sur 6.

4. Procédé de transmission de données de radiocommunication bidirectionnelle selon l'une des revendications précédentes, **caractérisé en ce que** la transmission de l'appareil central vers le terminal s'effectue avec un débit de données de 32 kcps et un codage Manchester.

5. Système de transmission de données de radiocommunication bidirectionnelle comprenant un terminal fonctionnant sur pile/batterie et pourvu d'un émetteur radioélectrique, un récepteur radioélectrique et d'une antenne radioélectrique ainsi qu'un appareil central pourvu d'un émetteur radioélectrique, un récepteur radioélectrique et d'une antenne directive, **caractérisé en ce**
**que** le système de transmission de données de radiocommunication est configuré pour mettre en oeuvre le procédé selon l'une des revendications précédentes.
